# EUROPEAN PATENT SPECIFICATION

(11) **EP 3 620 895 B1**
(45) Date of publication and mention of the grant of the patent: **13.07.2022**
(21) Application number: 18192518.1
(22) Date of filing: 04.09.2018
(51) Int. Cl.: G06F 3/01, H01L 41/09, H01L 41/193

(54) **REVERSIBLE ACTUATOR, METHOD FOR PRODUCING AND DEVICE USING THE SAME**
UMKEHRBARER AKTUATOR, VERFAHREN ZUR HERSTELLUNG UND VORRICHTUNG MIT VERWENDUNG DAVON
ACTIONNEUR RÉVERSIBLE, PROCÉDÉ DE PRODUCTION ET DISPOSITIF L'UTILISANT

(43) Date of publication of application: 11.03.2020
(73) Proprietor: Robert Bosch GmbH, 70442 Stuttgart (DE)
(72) Inventor: Jeon, Jin Han, 558962 Singapore (SG); So, Yong Heng, 564596 Singapore (SG)

(56) References cited:
- WO-A2-2018/127839
- US-A1- 2013 033 967
- US-A1- 2016 216 764

## Description

### FIELD OF TECHNOLOGY

The present disclosure relates to a reversible actuator, a method for producing a reversible actuator, and also to a haptic feedback interface device using the same, comprising a plurality of reversible actuators, for example a touch interface surface comprising the plurality of reversible actuators.

### BACKGROUND

There is an increasing trend of haptic applications for touch display interfaces such as consumer electronics (CE) and automotive dashboards. Haptic feedback recreates a tactile sensation in a user interface device by delivering either mechanical forces, pressures or vibrations to convey information to a user. In particular, a haptic actuator is the main component of a haptic system that provides mechanical actuation to deliver haptic perception for enhanced user experiences.

Today's smart phones, touch pads and touchscreen displays are mostly featured with vibrational haptic feedback driven by inertia-type actuators such as Eccentric Rotating Mass (ERM) and Linear Resonant Actuator (LRA). These actuators provide only whole device vibration and have several limitations particularly of bulky size, lack of realistic feedback and complex mechanical design.

US 20130033967 discloses a transducer module including a first transducer and a second transducer, wherein the second transducer is disposed between the first transducer and a first plate. The transducer 21 may be round, rectangular or have a tri-fork shape anchored to the first plane at the center. WO 2018/127839 A2 discloses a triboelectric-based sensors incorporating an actuator, co-located on the same substrate as the triboelectric-based sensor. The actuator and the triboelectric-based sensor may share an active polymer layer. US 2016/0216764 A1 discloses a mechanism including a material portion configured as a dome-shaped or arcuate diaphragm and made of metal that stores mechanical energy. A conductor such as a Nitinol wire may be bonded to the perimeter of the material, and has a variable length in response to an applied signal. A controller provides the electrical signal, and the mechanism responds by activating a haptic pop effect.

Therefore, there is a need to provide for improved haptic actuators.

### SUMMARY

It is therefore an object of the invention to provide an improved reversible actuator, an improved method for producing a reversible actuator.

A reversible actuator is provided according to a first aspect of the invention. The reversible actuator may also be called a haptic reversible actuator, or a surface coverage haptic reversible actuator. The reversible actuator includes an actuator substrate. The actuator substrate includes an electroactive layer, which is in contact with a first electrode and a second electrode. The electroactive layer is configured to change shape in response to an electrical signal applied to the first electrode and the second electrode. The actuator substrate includes a center and a plurality of radial slots radially extending from the center and further includes a plurality of segments. At least some of the slots of the plurality of radial slots terminate in enlarged apertures. Actuator substrate portions between two adjacent slots of the plurality of radial slots define a plurality of segments. For example, each segment of the plurality of segments is formed by an actuator substrate portion between two adjacent slots of the plurality of radial slots.

A method for producing a reversible actuator according to a second aspect of the invention. includes providing an actuator substrate. wherein the actuator substrate includes an electroactive layer. The method includes laser cutting a plurality of radial slots into the actuator substrate, wherein at least some of the slots of the plurality of radial slots terminate in enlarged apertures. The method includes shaping, for example hot pressing, a portion of the actuator substrate into a protruded portion.

A haptic feedback interface device according to various embodiments includes a plurality of reversible actuators according to the first aspect of the invention. The plurality of reversible actuators is provided on a common actuator substrate. The plurality of reversible actuators is electrically coupleable to a control circuit, so that an electrical signal can be applied independently to each of the plurality of reversible actuators or wholly to the plurality of reversible actuators, by the control circuit. The plurality of reversible actuators may be electrically coupled to the control circuit.

### BRIEF DESCRIPTION OF THE DRAWINGS

In the following description, various embodiments of the present disclosure are described with reference to the following drawings, in which:
FIG. 1 shows a schematic illustration of an exemplary reversible actuator 100 according to various embodiments;
FIG. 2 shows a schematic illustration of an exemplary layered structure of an actuator substrate 102 according to various embodiments;
FIG. 3 shows a schematic illustration of an exemplary reversible actuator 300 according to various embodiments, in perspective view;
FIG. 4A shows, on the upper view, a schematic illustration of an exemplary reversible actuator 400 according to various embodiments, wherein the segments of the plurality of segments 450 are unconnected from each other at a portion proximal to the center 430; a cross section of the reversible actuator 400 is shown at the middle, and line drawings of a top and perspective view of an example implementation of the actuator is shown in the lower view;
FIG. 4B shows, on the upper view, a schematic illustration of an exemplary reversible actuator 400 according to various embodiments, further comprising a centerpiece 470; a cross section of the reversible actuator 400 is shown at the middle, and a line drawing of a perspective view of an example implementation of the actuator is shown in the lower view;
FIG. 5A shows a schematic illustration of an exemplary reversible actuator 500.1 according to various embodiments, wherein at least some of the slots of the plurality of radial slots 540.1 terminate in enlarged apertures, for example squared-shaped enlarged apertures 560.1;
FIG. 5B shows a schematic illustration of an exemplary reversible actuator 500.2 according to various embodiments, wherein at least some of the slots of the plurality of radial slots 540.2 terminate in enlarged apertures, for example trapezoid-shaped enlarged apertures 560.2;
FIG. 6A shows a schematic illustration of a cross section of an exemplary reversible actuator 400, as shown in FIG. 4B, according to various embodiments, wherein the reversible actuator further comprises an elastic membrane 490;
FIG. 6B shows the cross section of the reversible actuator 400 of FIG. 6A, wherein the reversible actuator is in an elevated position;
FIG. 7A shows 3 different configurations for a reversible actuator and plot 700 showing the corresponding load vs. deformation curve;
FIG. 7B shows a plot 710 showing a load vs. deformation curve for reversible actuators with different height/thickness ratio;
FIG. 8A shows a petal shaped reversible actuator 800 which does not form part of the present invention;
FIG. 8B shows a plot 801 with a voltage vs. time signal 810 applied to the reversible actuator 800 and the correspondent force vs. time response 820 which does not form part of the invention;
FIG. 9A shows a reversible actuator 901 wherein the plurality of segments are arranged to form a protruded portion and wherein at least some of the slots of the plurality of radial slots terminate in enlarged apertures according to various embodiments;
FIG. 9B shows a plot 900 with a voltage vs. time signal 910 applied to the reversible actuator 901 and the correspondent force vs. time response 920.
FIG. 10 shows a reversible actuator 1000 including an active fulcrum ring 1051.
FIG. 11 shows a reversible actuator 1100 further including slits 1120 and/or spacer 1130 for decreasing the effective length of each segment, resulting in larger actuation force.

### DETAILED DESCRIPTION

The following detailed description describes specific details and embodiments in which the invention may be practiced. These embodiments are described in sufficient detail to enable those skilled in the art to practice the invention. Other embodiments may be utilized and changes may be made without departing from the scope of the invention. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The invention illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied herein disclosed may be resorted to by those skilled in the art, and that such modifications and variations are considered to be within the scope of this invention.

As used herein, the term "and/or" includes any and all combinations of one or more of the associated listed items.

The reference signs included in parenthesis in the claims are for ease of understanding of the invention and have no limiting effect on the scope of the claims.

In accordance to various embodiments, the term "electroactive layer" may mean a layer which may undergo a shape change in response to an applied electrical field. The electroactive layer may include an electroactive material, e.g. an electroactive polymer. Within the context of the present disclosure and in accordance to various embodiments, an electroactive material, e.g., an electroactive polymer (EAP), is a material (a polymer in case of EAP) that undergoes shape change in response to an applied electrical field.

In accordance to various embodiments, the term "shape" when describing an element comprising an electroactive layer such as a segment, may mean for example, a bending, a change in at least one dimension such as length, a change in volume, a change in conformation, or a combination thereof. For example, a change of shape of a segment of the plurality of segments may mean that the segment bends, e.g. to one side.

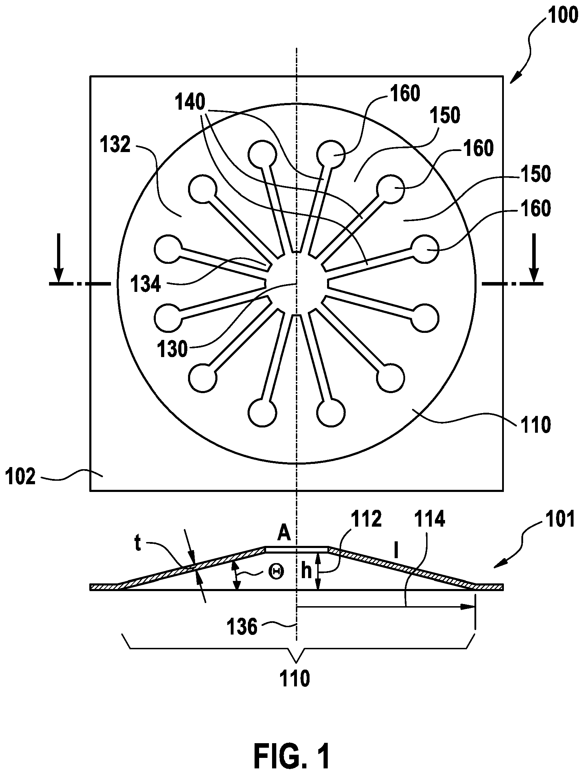

FIG**.** 1 shows a schematic illustration of an exemplary reversible actuator 100 according to various embodiments. The upper view is a top view of the reversible actuator 100. The lower view is a cross sectional view 101. The reversible actuator 100 comprises an actuator substrate 102. The actuator substrate includes a center 130 from which a plurality of radial slots 140 radially extends. The actuator substrate portions between two adjacent slots of the plurality of radial slots defines a plurality of segments 150. In FIG. 1 only a few of the plurality of slots and of the plurality of segments are indicated with reference numerals, however it is to be understood that the term "plurality" within the meaning of various embodiments, may mean 2 or more, for example all slots and/or all of the segments. The segments of the plurality of segments includes a portion 134, for example an end, which is proximal to the center 130 and a part 132, which is distal from the center 130. The actuator substrate includes a protruded portion 110, for example as shown in the cross section 101. The protruded portion 110 is shown, for illustrative purposes, protruded out of the actuator substrate's plane, for example to a surface of the actuator substrate 102. The protrusion includes an axis 136 and further includes a rotational symmetry with respect to the axis 136. The central portion is elevated by a height 112, which elevation decreases in radial direction 114 to substantially zero.

The term "protruded portion" also named "protrusion", within the meaning of various embodiments, may mean that a central portion of the actuator substrate is at a height from the surrounding actuator substrate plane, for example the segment portions of the plurality of segments which are proximal to the center are at a height from the actuator substrate's plane. The actuator substrate plane may be defined as the plane crossing a portion of the actuator substrate not including the protruded portion. For example, the actuator substrate's plane may be a plane crossing the distal parts of the segment portions of the plurality of segments which is distal from the center. The protruded portion may be, for example, a dome with a circular basis, a dome with a regular convex polygonal basis, a cone, or a frustum of the foregoing. The protruded portion may include an axis and may further include a rotational symmetry with respect to the axis.

According to various embodiments, the protruded portion may be the first configuration, for example in which the reversible actuator is in a rest position. The protruded portion may be produced by conforming the segments of the plurality of segments to a desired shape, for example by stamping, pressing, or hot pressing the actuator substrate into the desired shape.

According to various embodiments, the segments of the plurality of segments may be connected to each other at a portion distal from the center 130. As shown in FIG. 1, the segments, which may also be called actuation fingers, may extend towards the center 130. According to various embodiments, the segments may be radially slotted segments, also called radially slotted actuation fingers. For example, the segments of the plurality of segments may be connected to each other only at a portion distal from the center 130. Each segment of the plurality of segments 150, for example each segment of all the plurality of segments 150, may be unconnected from the adjacent segments, and for example, from all other segments of the plurality of segments 150, at the portion 134 which is proximal to the center 130. A central opening hole may be formed at the center 130.

According to various embodiments, and as shown in the cross sectional view of FIG. 1 for illustrative purposes, the protruded portion 110 may further include a height 112, and may further include a first configuration and a second configuration, in which first configuration the height 112 is different from the second configuration. For example, the first configuration may be a rest configuration, under which no load is applied, and the second configuration may be a configuration under application of a load. The height may be adjusted in response to electrical signal applied to the at least one segment, for example to all segments of the plurality of segments. The electrical signal may cause an electrical stimulation on the plurality of segments, for example on an electroactive layer(s) and thus cause a change in shape of the respective segment, for example of all segments of the of the plurality of segments.

The term "load", for example as in "external load" or "applied load", within the meaning of various embodiments, may mean a force applied by the electroactive polymer to the plurality of segments or may mean an external force applied to the plurality of segments, for example by an user, or it may mean both. When it is solely referred to an external force applied to the plurality of segments, for example by a user, the expression "external load" may be used. The external load may be applied indirectly to the plurality of segments, for example via a centerpiece and/or via an elastic membrane.

According to various embodiments, the actuator may include an elastic membrane superposed on the actuator substrate of the reversible actuator. Alternatively or in addition, the actuator substrate may include an elastic cover layer.

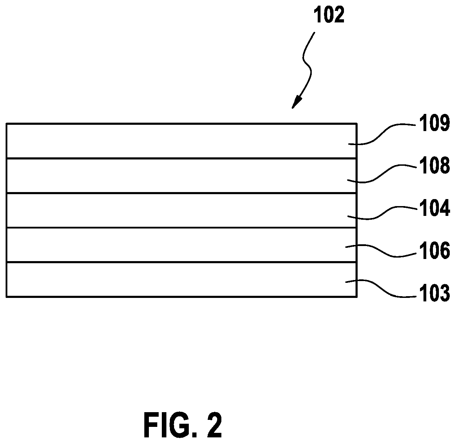

FIG. 2 shows a schematic illustration of an actuator substrate 102. The actuator substrate 102 may include a support layer 103. The actuator substrate 102 may further include an electroactive layer 104 between a first electrode 106 and a second electrode 108, the electroactive layer and the first and second electrodes may be included on the whole actuator substrate or only on portions thereof, for example on the protruded portion. The first electrode 106 may be disposed on the support layer 103. The actuator substrate may further include an elastic cover 109. The elastic cover layer 109 may be disposed on a second electrode layer 108. The electroactive layer may comprise an electroactive polymer (EAP). Examples of electroactive polymers may include: dielectric EAP (dEAP), ferroelectric polymer (FerroEAP), ionic EAP (iEAP).

Ionic EAP (iEAP) may be used to generate large bending deformation under low driving voltage (< 5 V), and are therefore a good soft actuator technology particularly for surface coverage haptic actuator applications. Some advantages of iEAP are low voltage driving mechanisms, fast response, reliability, large actuation force and out-of-plane (protrusion type) deformation. Furthermore, snap-through and bi-stable mechanism may be applied to the design of the reversible actuators, e.g. buckled iEAP based cantilever actuators, in accordance to various embodiments.

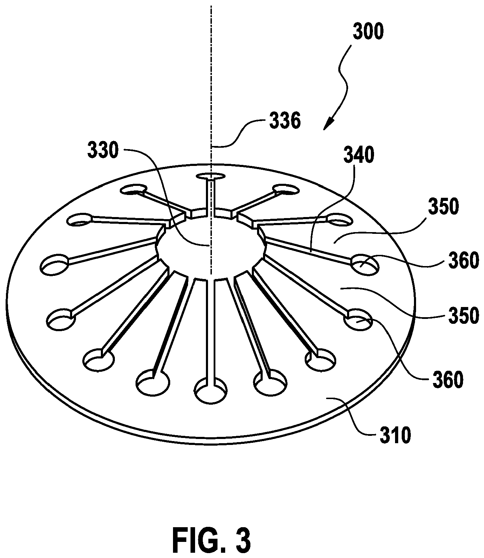

FIG. 3 shows a perspective view of an exemplary reversible actuator 300 according to various embodiments. The actuator substrate includes a center 330 on an axis 336, from which a plurality of radial slots 340 radially extends. The actuator substrate portions between two adjacent slots of the plurality of radial slots 340 define a plurality of segments 350. At an end of the slots 340, which end is distal from the center 330, an enlarged aperture is provided in the actuator substrate.

According to various embodiments, at least some of the slots of the plurality of radial slots terminate in enlarged apertures. For example, an enlarged aperture is provided at the end of each of the slots. The enlarged aperture is continuously connected with the plurality of radial slots, for example each enlarged aperture forms a continuous trough opening with a respective slot from the plurality of radial slots. The enlarged aperture, for example all enlarged apertures, may be, for example, quadratic, rectangular, circular, trapezoid, D-shaped. As used herein the enlarged apertures are also called slot end holes.

According to various embodiments, the protruded portion includes a height, and further includes a first configuration and a second configuration, in which first configuration the height is different from the second configuration. For example, the height in the second configuration may be less than the height in the first configuration. In another example, the height in the second configuration may be greater than the height in the first configuration.

According to various embodiments of the method, the reversible actuator is fabricated through hot-press and laser cutting process to achieve specific design parameters, for example, at least one of actuator substrate thickness, length of the segments of the plurality of segments, shape of the enlarged aperture, height of the protrusion in rest configuration. For example, ionic electroactive polymers are processed with hot-press and/or laser cutting processes.

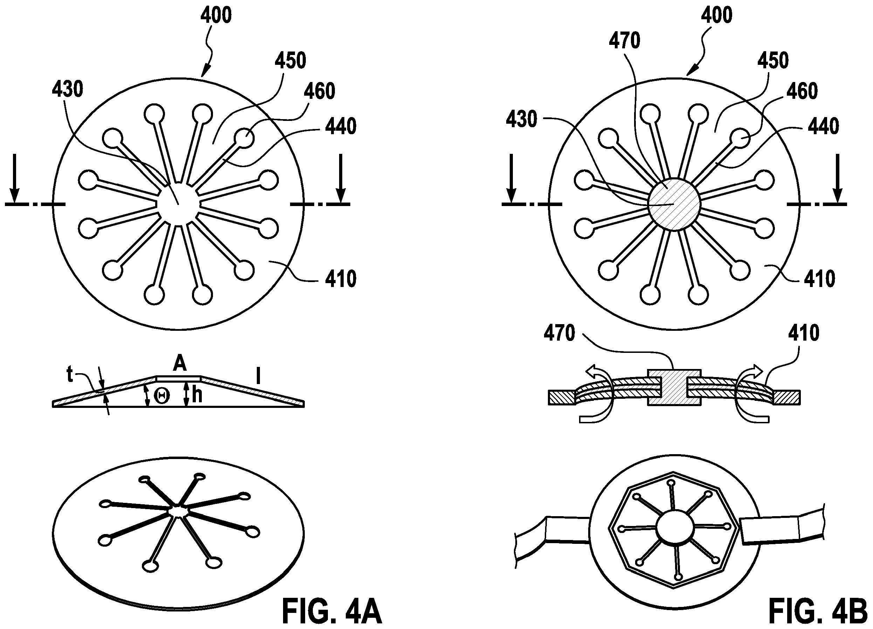

FIG. 4A shows, on the upper view, a schematic illustration of an exemplary reversible actuator 400 according to various embodiments, wherein the segments of the plurality of segments 450 are unconnected from each other at a portion proximal to the center 430. In other words, the segments are radially slotted actuation fingers which may include a protruded portion, and wherein each of the slots includes a slot end hole (enlarged aperture). A cross section of the reversible actuator 400 is shown at the middle, and a line drawing of a perspective view of an example implementation of the actuator is shown in the lower view. The key design parameters may include at least one of: an actuator substrate thickness (t), the protrusion height (h), an open area (A), an angle (θ) and a segment length (I). The following properties of a reversible actuator may be adjusted by configuring the design parameters: protrusive motion, force under electrical excitation, release mechanism, elastic restoring force. A rapid, large and reversible protrusive morphing motion may be generated in range of 1.5 < h/t (height-thickness ratio) based on the diaphragm spring design with radially slotted actuation fingers. Thus, the proper h/t ranges can be exploited to generate large reversible deformation under reduced external load (small electrical excitation). For example, at diaphragm layer thickness range of 0.7 - 1.0 mm, the range of diaphragm height may be 1.2 - 1.4 mm.

FIG. 4B shows, on the upper view, a schematic illustration of an exemplary reversible actuator 400 according to various embodiments, further comprising a centerpiece 470. A cross section of the reversible actuator 400 is shown at the middle, and a line drawing of a perspective view of an example implementation of the actuator is shown in the lower view. The reversible actuator in FIG. 4B includes a centerpiece 470 at the center 430, for example a central plate or a central pad.

According to various embodiments, the centerpiece may be located and/or interconnected on a central opening hole of the reversible actuator. The centerpiece may be configured to interact with some or all of the plurality of segments, for example to constrain the shape change of the plurality of segments, e.g. due to the shape change of the electroactive layer. The centerpiece may have a rotational symmetry. The centerpiece may be, for example, a body of revolution. The centerpiece may include one or two endplates, for example, configured to constrain movement in axial direction. The centerpiece enables combining actuation force and balancing movement of plurality of segments, for example of all segments of the plurality of segments, resulting in larger protrusive and morphing motion.

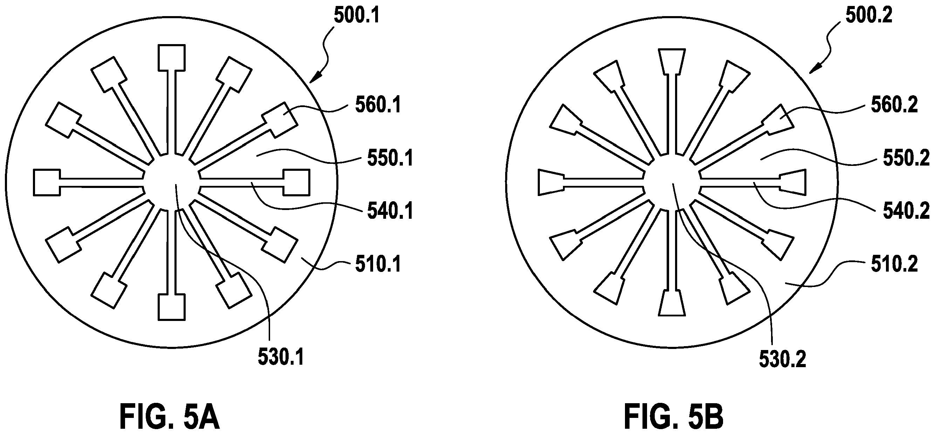

FIG. 5A shows a schematic illustration of an exemplary reversible actuator 500.1 according to various embodiments, wherein at least some of the slots of the plurality of radial slots 540.1 terminate in enlarged apertures, for example squared-shaped enlarged apertures 560.1. The reversible actuator 500.1 has, for illustrative purposes, 12 slots 540.1 and 12 segments 510.1. More slots and more segments, or less slots and less segments may be provided.

According to various embodiments, the plurality of segments may include at least 2, at least 3, at least 4, at least 5, or at least 6 segments. According to various embodiments, the expression a "plurality of segments" may mean the plurality of segments which are functional according to the invention, other segments, which have other functions not described herein may not necessarily be included in the meaning of "plurality of segments". Also, in accordance to various embodiments, a segment or segments of the "plurality of segments", for example a segment which is electro active, may refer to some of the segments of the plurality of segments, to each of the segments of the plurality of segments, or to all segments of the plurality of segments.

FIG. 5B shows a schematic illustration of an exemplary reversible actuator 500.2 according to various embodiments, wherein at least some of the slots of the plurality of radial slots 540.2 terminate in enlarged apertures, for example trapezoid-shaped enlarged apertures 560.2. The reversible actuator 500.2 has, for illustrative purposes, 12 slots 540.2 and 12 segments 510.2. More slots and more segments, or less slots and less segments may be provided.

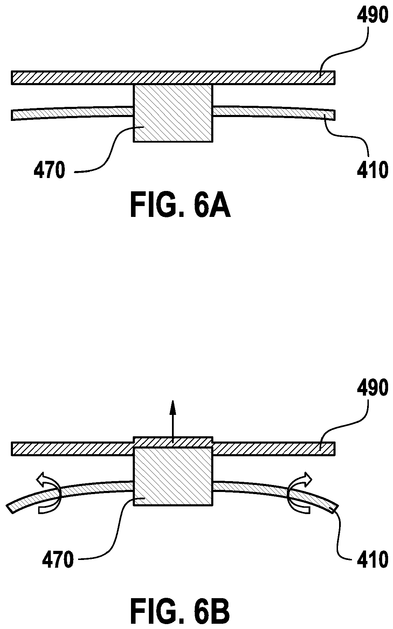

FIG. 6A and FIG. 6B show a schematic illustration of a cross section of an exemplary reversible actuator in two configurations, for illustration purposes it is the cross section of the reversible actuator of FIG. 4B. According to various embodiments, the reversible actuator may further include an elastic membrane 490 superposed on the actuator substrate of the reversible actuator. The elastic membrane 490 may be configured to be elastically deformable upon application of a force applied to the centerpiece 470, for example the force may be applied by the segments of the plurality of segments of the protrusion portion 410 to the elastic membrane 490.

The reversible actuator may include a first configuration and a second configuration, and optionally further configurations. For example in the first configuration, as shown in FIG. 6A, the protruded portion 410 has a first height, such that the centerpiece 470 is in a first position relative to the elastic membrane 490. For example, in a second configuration, as shown in FIG. 6B, the protruded portion 410 has a second height smaller than the second height, and the centerpiece 470 applies a force on the elastic membrane 490. This causes a morphing of the elastic membrane 490. In this case, the centerpiece 470 plays a relevant role in allowing the morphing motion to create a sharp edge deformation as shown in FIG. 6A and 6B.

According to various embodiments, the elastic membrane may be, for example, an integrated protective overcoat layer with elastic properties, integrated on top of the iEAP diaphragm button. An elastic membrane enables mechanical morphing deformation with sharp edges. The sharp edges can be conceptually proved via the perpendicular movement of the centerpiece due to morphing motion of those underneath actuating segments. Such sharp edge deformation is beneficial as it further enhances the haptic perception of user operating the reversible actuator, for example a reversible actuator in a haptic interface.

According to various embodiments, the reversible actuator may be configured to work in various modes, for example at least one of the foregoing, or combinations thereof:
a) touch sensor mode: upon application of external load a corresponding electric signal may be measured. In particular, upon change of configuration due to change in an applied external load, an electrical signal may be measured as indicative of the change in configuration. Due to the change of external load applied on the segments of the plurality of segments, and thus to the electroactive layer, the electroactive layer may provide a corresponding electric signal. A corresponding circuit may be provided for sensing the electrical signal. In one example, the touch sensor mode may be a push-button mode;
b) haptic feedback mode 1: upon application of an electrical signal to the electroactive layer, the resulting load may be sufficient, for example, to change the reversible actuator from a first configuration to a second configuration wherein the height in the first configuration (h1) is less than the height in the second configuration (h2), and, may be sufficient to change the reversible actuator from the second configuration to a further configuration. Thus, for example, if a user touches the reversible actuator, for example with a finger, he may sense the reversible actuator buckle away from the finger. In another example, the user may sense the reversible actuator vibrate in a direction forth and away from the finger;
c) haptic feedback mode 2: upon application of an electrical signal to the electroactive layer, the resulting load may be sufficient, for example, to change the reversible actuator from a first configuration to a second configuration wherein the height in the first configuration (h1) is greater than the height in the second configuration (h2). Thus, for example, if a user is touching the reversible actuator, for example with a finger, he may sense the reversible actuator morph towards the finger. In another example, the user may sense the reversible actuator vibrate in a direction forth and away from the finger.

According to various embodiments, modes a), b), and c) may be combined in a same reversible actuator. For example, the actuator may be configured to provide modes a) and b). In another example, the actuator may be configured to provide modes a) and c). In yet another example, the actuator may be configured to provide modes b) and c). In yet another example, the actuator may be configured to provide modes a), b) and c).

According to various embodiments, the actuator is a haptic feedback actuator, for example, a haptic feedback interface device.

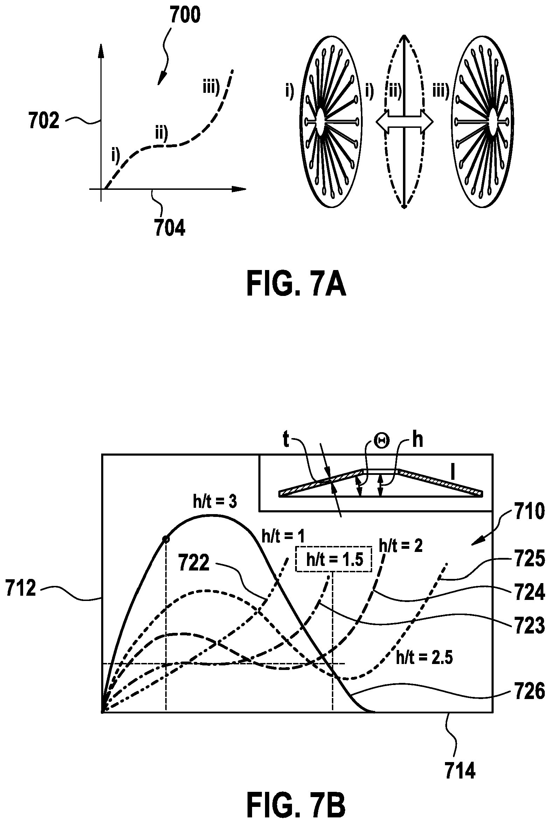

FIG. 7A shows, on the right side, 3 different configurations (i)-(iii) for a reversible actuator and on the left side, a plot 700 showing the corresponding load vs. deformation curve for the 3 configurations. In a first configuration (i), no load is applied or only a load which is too small for a change of configuration is applied. When a load of sufficient force is applied, the reversible actuator may change from the first configuration (i) to the second configuration (ii). In a second configuration (ii), when a load of sufficient force is applied, the reversible actuator may change from the second configuration (ii) to the third configuration (iii). The several protrusive actuation/morphing behaviors of the reversible actuator are shown. The exact curve (such as shown in plot 700) may depend on the specifically designed parameters, for example the diaphragm thickness (t) and height (h).

According to various embodiments, the applied load may be due to actuation of the segments of the plurality of segments under electrical stimulation, for example, a transverse force due to the electroactive layer (e.g. an iEAP layer) actuation. Under an applied load, for example, due to the actuation of the segments, the reversible actuator may undergo various protrusive deformation states as depicted in FIG. 7A. FIG. 7B shows a plot 710 showing a load vs. deformation curve for reversible actuators with different height/thickness ratio. A large thrust force could be generated based on such protrusive deformation of the reversible actuator. Furthermore, a fast and reliable two-way motion (snap-through buckling behaviour) can be realized due to the release mechanism and elastic restoring force of the reversible actuator according to various embodiments, for example due to a curved diaphragm spring design (coning shape). Also, the plurality of segments may include a center hole (e.g. the segments may be short so to not extend to the center) allowing a good distribution of concentrated stresses created during actuation of the plurality of segments. As shown in FIG. 7B, the snap-through behavior of the reversible actuator may be achieved, for example, with a height-thickness ratio (h/t) in range of 1.5 < h/t < 2.5. The h/t can be exploited to generate large protrusive deformation under reduced load, such as small electrical excitation.

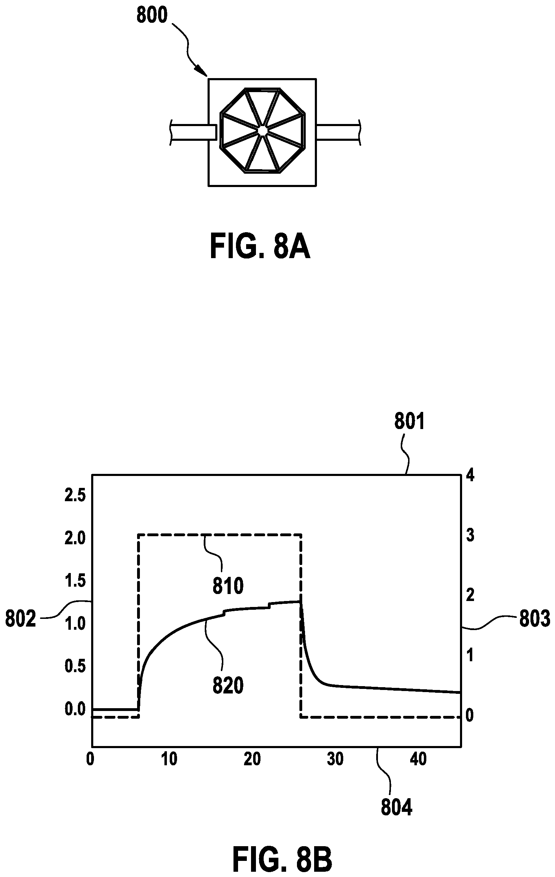

FIG. 8A and 8B do not form part of the present invention, and are herein included to provide a comparative example to the reversible actuator according to the various embodiments of the present invention. FIG. 8A shows a reversible actuator 800, which is petal shaped and includes an iEAP layer, with 8 slotted segments, in form of cantilever fingers, to generate load, which may lead to, e.g., protrusive morphing actuation. FIG. 8B shows a plot 801 including a curve 810 of the applied voltage 803 (in volts) as function of time 804 (in seconds), and further including a curve 820 of the force 802 (in gf - gram force) as function of time 804 (in seconds). As can be seen in FIG. 8B, the generated force is 1.25 gf and the response time is more than 20s to reach maximum force.

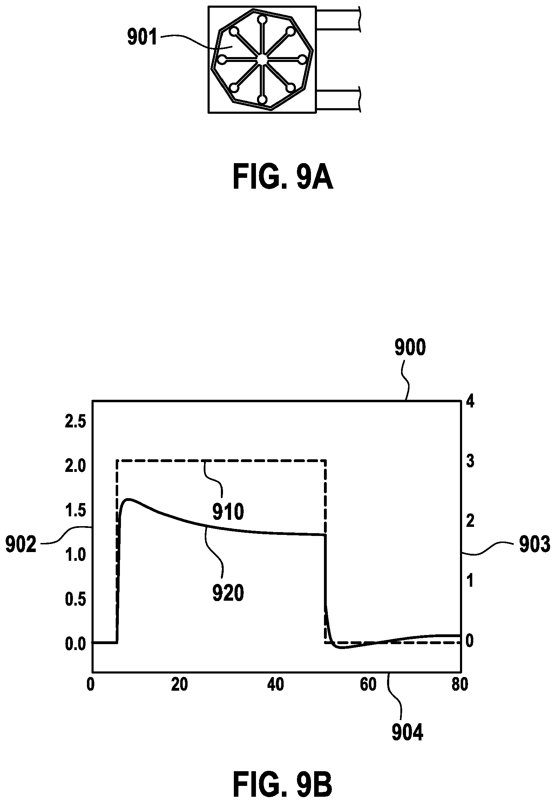

FIG. 9A shows a reversible actuator 901 wherein the plurality of segments are arranged to form a protruded portion. The reversible actuator of FIG. 9A also includes an iEAP layer, and exhibits an improved actuation force of 1.75 gf and fast morphing time of less than 5s as can be seen in FIG. 9B. FIG. 9B shows a plot 900 including a curve 910 of the applied voltage 903 (in volts) as function of time 904 (in seconds), and further including a curve 920 of the force 902 (in gf) as function of time 904 (in seconds). The response time and force of the reversible actuator 901 with curved diaphragm spring design (coning shape), with slot end holes and a protruded portion, are improved over the reversible actuator with normal petal shaped diaphragm of FIG. 8A. The improvement is due to the well-distributed force of the plurality of segments, for example, during actuation, and the release mechanism, meaning the elastic restoring force, of the protruded portion.

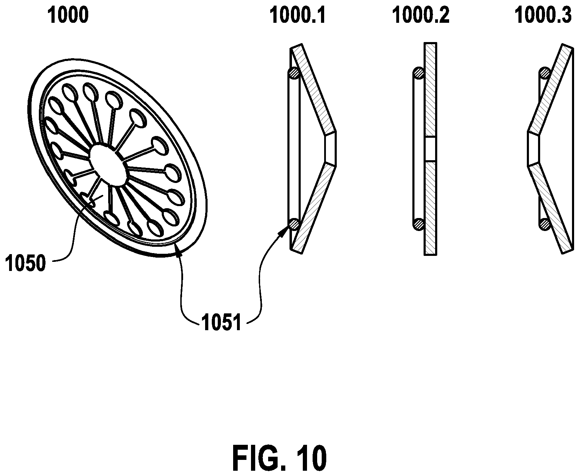

FIG. 10 shows a reversible actuator 1000 in accordance to various embodiments. The reversible actuator 1000 may include a plurality of segments 1050 arranged to form a protruded portion and an active fulcrum ring 1051. The active fulcrum ring may include an electroactive material and may thus be implemented as an electroactive fulcrum ring. By actuating the active ring, the actuation of the reversible actuator may be improved, for example providing a faster actuation. In accordance to various embodiments, an electroactive fulcrum ring may be configured to, upon electrical stimulation, perform a change of shape, for example in at least one dimension such as length, a change in volume, a change in conformation, or a combination thereof. For example, a change of shape of a fulcrum ring may mean that the fulcrum ring contracts or expands.

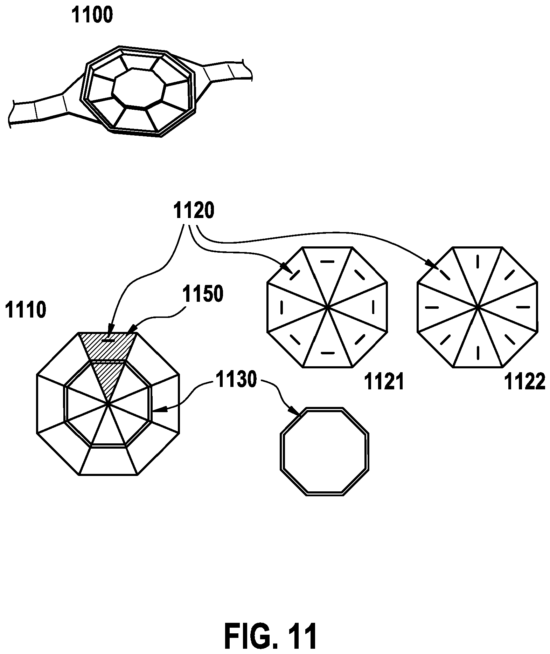

FIG. 11 shows an reversible actuator 1100 wherein the plurality of segments 1150 are arranged to form a protruded portion. One or more of the plurality of segments may include a slit 1120. Its orientation, dimensions (width, length), number and location may affect the actuation performance of an improved reversible actuator. For example the slits may be of arced configuration 1121 and/or radial configuration 1122. Arced slits may form an arc with cavity directed to the center of the actuator substrate, for example the arced slits may be slits of circular arc having a common circular center at center of the actuator substrate. Radial slits may be, for example, radial segments of radii originating at the center of the actuator. The slits may help reducing bending stiffness, resulting in larger displacement and faster actuation response.

According to various embodiments, the reversible actuator may include a spacer, which may be configured to decrease the effective length of each segment. The decrease of the effective length of the segments may induce a larger actuation force. An example of such a spacer is illustrated in FIG. 11, wherein the actuator 1100 includes spacer 1130. A combination of slits and spacer may further enhance the actuation force by changing effective length and bending stiffness of each segment. The slit location after using spacer may be on the 1/3 of the effective segment length, which 1/3 is distal from the center of the actuator substrate.

An interface include a plurality of reversible actuators according to various embodiments of the present disclosure. The plurality of reversible actuators may be arranged according to a pre-defined pattern, for example a matrix structure. The interface may be, for example, a keyboard, part of a touch screen, or part of a display. For example a display may include the interface. In another example, a touch screen may include the interface. The plurality of reversible actuators may be positioned, for example, over or under a display layer.

## Claims

1. A reversible actuator (100, 300, 400, 500, 800, 901, 1000, 1100), comprising an actuator substrate (102), the actuator substrate (102) comprising an electroactive layer (104) in contact with a first electrode (106) and a second electrode (108), wherein the electroactive layer (104) is configured to change shape in response to an electrical signal applied to the first electrode (106) and the second electrode (108), and wherein the actuator substrate comprises a center (130, 330) and
**characterized in that** the actuator further comprises:
a plurality of radial slots (140, 340, 440 540.1, 540.2) radially extending from the center (130, 330, 430, 530.1, 530.2), wherein actuator substrate portions between two adjacent slots of the plurality of radial slots (140, 340, 440, 540.1, 540.2) define a plurality of segments (150, 350, 450, 550.1, 550.2, 1050, 1150), wherein at least some of the slots of the plurality of radial slots (140, 340, 440, 540.1, 540.2) terminate in enlarged apertures (160, 360, 460, 560.1, 560.2).

2. The reversible actuator (100, 300, 400, 500, 800, 901, 1000, 1100) of claim 1, wherein the segments of the plurality of segments (150, 350, 450, 550.1, 550.2, 1050, 1150) are connected to each other at a portion distal (132) from the center (130, 330, 430, 530.1, 530.2).

3. The reversible actuator (100, 300, 400, 500, 800, 901, 1000, 1100) of claim 1 or 2, wherein the segments of the plurality of segments (150, 350, 450, 550.1, 550.2, 1050, 1150) are unconnected from each other at a center (130, 330, 430, 530.1, 530.2).

4. The reversible actuator (100, 300, 400, 500, 800, 901, 1000, 1100) of any of claims 1 to 3, wherein the electroactive layer (104) comprises an electroactive polymer.

5. The reversible actuator (100, 300, 400, 500, 800, 901, 1000, 1100) of any of claims 1 to 4, wherein a shape change of the electroactive layer is constrained for the plurality of segments (150, 350, 450, 550.1, 550.2, 1050, 1150) in radial direction (114).

6. The reversible actuator (100, 300, 400, 500, 800, 901, 1000, 1100) of claim 5, further comprising a centerpiece (470) at the center (430), and preferably wherein the shape change of the electroactive layer in radial direction (114) is constrained by the centerpiece (470).

7. The reversible actuator (100, 300, 400, 500, 800, 901, 1000, 1100) of claim 6, further comprising an elastic membrane (490) superposed on the actuator substrate and configured to be elastically deformable upon application of a force applied to the centerpiece.

8. The reversible actuator (100, 300, 400, 500, 800, 901, 1000, 1100) of any of claims 1 to 7, further comprising an active fulcrum ring (1051), wherein the active fulcrum ring comprises an electroactive material.

9. The reversible actuator (100, 300, 400, 500, 800, 901, 1000, 1100) of any of claims 1 to 8, wherein one or more of the plurality of segments comprises a radial slit and/or an arced slit (1120, 1121, 1122).

10. The reversible actuator (100, 300, 400, 500, 800, 901, 1000, 1100) of any of claims 1 to 9, wherein the plurality of segments (150, 350, 450, 550.1, 550.2, 1050, 1150) are arranged to form a protruded portion (110, 310, 410, 510.1, 510.2), which protrudes to a surface of the actuator substrate (102).

11. The reversible actuator (100, 300, 400, 500, 800, 901, 1000, 1100) of claim 10, wherein the protruded portion (110, 310, 410, 510.1, 510.2) comprises a height (112), and further comprises a first configuration and a second configuration, in which first configuration the height (112) is different from the second configuration.

12. The reversible actuator (100, 300, 400, 500, 800, 901, 1000, 1100) of claim 11, further configured so that the height (112) is adjustable in response to the electrical signal.

13. The reversible actuator (100, 300, 400, 500, 800, 901, 1000, 1100) of claim 11 or 12, wherein the first configuration is a rest configuration.

14. The reversible actuator (100, 300, 400, 500, 800, 901, 1000, 1100) of any of claims 11 to 13, wherein the protruded portion is configured to be brought from the first configuration to the second configuration by a load.

15. A method for producing a reversible actuator (100, 300, 400, 500, 800,901, 1000, 1100) according to any of claims 10 to 14, the method comprising:
providing the actuator substrate (102) comprising the electroactive layer (104);
**characterized by**:
laser cutting the plurality of radial slots (140, 340, 440, 540.1, 540.2) into the actuator substrate (102), wherein at least some of the slots of the plurality of radial slots (140, 340, 440, 540.1, 540.2) terminate in enlarged apertures (160, 360, 460, 560.1, 560.2);
hot pressing a portion of the actuator substrate (102) into the protruded portion (110, 310, 410, 510.1, 510.2).

16. A haptic feedback interface device comprising a plurality of reversible actuators (100, 300, 400, 500, 800, 901, 1000, 1100) according to any of claims 1 to 14, wherein the plurality of reversible actuators (100, 300, 400, 500, 800, 901, 1000, 1100) are provided on a common actuator substrate, and are electrically coupleable to a control circuit so that an electrical signal may be applied independently to each of the plurality of reversible actuators (100, 300, 400, 500, 800, 901, 1000, 1100), by the control circuit.

## Patentansprüche

1. Reversibler Aktuator (100, 300, 400, 500, 800, 901, 1000, 1100), umfassend ein Aktuatorsubstrat (102), wobei das Aktuatorsubstrat (102) eine elektroaktive Schicht (104) in Kontakt mit einer ersten Elektrode (106) und einer zweiten Elektrode (108) umfasst, wobei die elektroaktive Schicht (104) dazu ausgelegt ist, in Reaktion auf ein an die erste Elektrode (106) und die zweite Elektrode (108) angelegtes elektrisches Signal die Form zu ändern, und wobei das Aktuatorsubstrat eine Mitte (130, 330) umfasst und **dadurch gekennzeichnet, dass** der Aktuator ferner Folgendes umfasst:
eine Mehrzahl von radialen Schlitzen (140, 340, 440, 540.1, 540.2), die sich von der Mitte (130, 330, 430, 530.1, 530.2) radial erstrecken, wobei Aktuatorsubstratabschnitte zwischen zwei benachbarten Schlitzen der Mehrzahl von radialen Schlitzen (140, 340, 440, 540.1, 540.2) eine Mehrzahl von Segmenten (150, 350, 450, 550.1, 550.2, 1050, 1150) definieren, wobei zumindest einige der Schlitze der Mehrzahl von radialen Schlitzen (140, 340, 440, 540.1, 540.2) in vergrößerten Öffnungen (160, 360, 460, 560.1, 560.2) enden.

2. Reversibler Aktuator (100, 300, 400, 500, 800, 901, 1000, 1100) nach Anspruch 1, wobei die Segmente der Mehrzahl von Segmenten (150, 350, 450, 550.1, 550.2, 1050, 1150) an einem Abschnitt distal (132) von der Mitte (130, 330, 430, 530.1, 530.2) miteinander verbunden sind.

3. Reversibler Aktuator (100, 300, 400, 500, 800, 901, 1000, 1100) nach Anspruch 1 oder 2, wobei die Segmente der Mehrzahl von Segmenten (150, 350, 450, 550.1, 550.2, 1050, 1150) an einer Mitte (130, 330, 430, 530.1, 530.2) voneinander getrennt sind.

4. Reversibler Aktuator (100, 300, 400, 500, 800, 901, 1000, 1100) nach einem der Ansprüche 1 bis 3, wobei die elektroaktive Schicht (104) ein elektroaktives Polymer umfasst.

5. Reversibler Aktuator (100, 300, 400, 500, 800, 901, 1000, 1100) nach einem der Ansprüche 1 bis 4, wobei eine Formänderung der elektroaktiven Schicht für die Mehrzahl von Segmenten (150, 350, 450, 550.1, 550.2, 1050, 1150) in radialer Richtung (114) beschränkt ist.

6. Reversibler Aktuator (100, 300, 400, 500, 800, 901, 1000, 1100) nach Anspruch 5, der ferner ein Mittelstück (470) in der Mitte (430) umfasst, und vorzugsweise wobei die Formänderung der elektroaktiven Schicht in radialer Richtung (114) durch das Mittelstück (470) beschränkt ist.

7. Reversibler Aktuator (100, 300, 400, 500, 800, 901, 1000, 1100) nach Anspruch 6, der ferner eine elastische Membran (490) umfasst, die an dem Aktuatorsubstrat überlagert und dazu ausgelegt ist, bei Aufbringen einer auf das Mittelstück aufgebrachten Kraft elastisch verformbar zu sein.

8. Reversibler Aktuator (100, 300, 400, 500, 800, 901, 1000, 1100) nach einem der Ansprüche 1 bis 7, der ferner einen aktiven Drehring (1051) umfasst, wobei der aktive Drehring ein elektroaktives Material umfasst.

9. Reversibler Aktuator (100, 300, 400, 500, 800, 901, 1000, 1100) nach einem der Ansprüche 1 bis 8, wobei eines oder mehrere der Mehrzahl von Segmenten einen radialen Schlitz und/oder einen bogenförmigen Schlitz (1120, 1121, 1122) umfasst.

10. Reversibler Aktuator (100, 300, 400, 500, 800, 901, 1000, 1100) nach einem der Ansprüche 1 bis 9, wobei die Mehrzahl von Segmenten (150, 350, 450, 550.1, 550.2, 1050, 1150) derart angeordnet sind, dass sie einen hervorstehenden Abschnitt (110, 310, 410, 510.1, 510.2) ausbilden, der zu einer Oberfläche des Aktuatorsubstrats (102) hervorsteht.

11. Reversibler Aktuator (100, 300, 400, 500, 800, 901, 1000, 1100) nach Anspruch 10, wobei der hervorstehende Abschnitt (110, 310, 410, 510.1, 510.2) eine Höhe (112) umfasst, und ferner eine erste Auslegung und eine zweite Auslegung umfasst, wobei sich in der ersten Auslegung die Höhe (112) von der zweiten Auslegung unterscheidet.

12. Reversibler Aktuator (100, 300, 400, 500, 800, 901, 1000, 1100) nach Anspruch 11, der ferner derart ausgelegt ist, dass die Höhe (112) in Reaktion auf das elektrische Signal anpassbar ist.

13. Reversibler Aktuator (100, 300, 400, 500, 800, 901, 1000, 1100) nach Anspruch 11 oder 12, wobei die erste Auslegung eine Ruheauslegung ist.

14. Reversibler Aktuator (100, 300, 400, 500, 800, 901, 1000, 1100) nach einem der Ansprüche 11 bis 13, wobei der hervorstehende Abschnitt dazu ausgelegt ist, durch eine Last von der ersten Auslegung in die zweite Auslegung gebracht zu werden.

15. Verfahren zum Herstellen eines reversiblen Aktuators (100, 300, 400, 500, 800, 901, 1000, 1100) nach einem der Ansprüche 10 bis 14, wobei das Verfahren Folgendes umfasst: Bereitstellen des Aktuatorsubstrats (102), das die elektroaktive Schicht (104) umfasst; **gekennzeichnet durch**:
Laserschneiden der Mehrzahl von radialen Schlitzen (140, 340, 440, 540.1, 540.2) in das Aktuatorsubstrat (102), wobei zumindest einige der Schlitze der Mehrzahl von radialen Schlitzen (140, 340, 440, 540.1, 540.2) in vergrößerten Öffnungen (160, 360, 460, 560.1, 560.2) enden;
Heißpressen eines Abschnitts des Aktuatorsubstrats (102) in den hervorstehenden Abschnitt (110, 310, 410, 510.1, 510.2) .

16. Haptische Rückkopplungsschnittstellenvorrichtung, die eine Mehrzahl von reversiblen Aktuatoren (100, 300, 400, 500, 800, 901, 1000, 1100) nach einem der Ansprüche 1 bis 14 umfasst, wobei die Mehrzahl von reversiblen Aktuatoren (100, 300, 400, 500, 800, 901, 1000, 1100) auf einem gemeinsamen Aktuatorsubstrat bereitgestellt sind, und mit einer Steuerschaltung derart elektrisch koppelbar sind, dass ein elektrisches Signal unabhängig an jeden der Mehrzahl von reversiblen Aktuatoren (100, 300, 400, 500, 800, 901, 1000, 1100) durch die Steuerschaltung angelegt werden kann.

## Revendications

1. Actionneur réversible (100, 300, 400, 500, 800, 901, 1000, 1100), comprenant un substrat d'actionneur (102), le substrat d'actionneur (102) comprenant une couche électroactive (104) en contact avec une première électrode (106) et une seconde électrode (108), dans lequel la couche électroactive (104) est configurée pour changer de forme en réponse à un signal électrique appliqué à la première électrode (106) et à la seconde électrode (108), et dans lequel le substrat d'actionneur comprend un centre (130, 330) et **caractérisé en ce que** l'actionneur comprend en outre :
une pluralité de fentes radiales (140, 340, 440, 540.1, 540.2) s'étendant radialement depuis le centre (130, 330, 430, 530.1, 530.2), dans lequel des parties de substrat d'actionneur entre deux fentes adjacentes de la pluralité de fentes radiales (140, 340, 440, 540.1, 540.2) définissent une pluralité de segments (150, 350, 450, 550.1, 550.2, 1050, 1150), dans lequel au moins certaines des fentes de la pluralité de fentes radiales (140, 340, 440, 540.1, 540.2) se terminent en ouvertures élargies (160, 360, 460, 560.1, 560.2).

2. Actionneur réversible (100, 300, 400, 500, 800, 901, 1000, 1100) selon la revendication 1, dans lequel les segments de la pluralité de segments (150, 350, 450, 550.1, 550.2, 1050, 1150) sont reliés les uns aux autres au niveau d'une partie distale (132) depuis le centre (130, 330, 430, 530.1, 530.2).

3. Actionneur réversible (100, 300, 400, 500, 800, 901, 1000, 1100) selon la revendication 1 ou 2, dans lequel les segments de la pluralité de segments (150, 350, 450, 550.1, 550.2, 1050, 1150) sont désaccouplés les uns des autres au niveau d'un centre (130, 330, 430, 530.1, 530.2) .

4. Actionneur réversible (100, 300, 400, 500, 800, 901, 1000, 1100) selon l'une quelconque des revendications 1 à 3, dans lequel la couche électroactive (104) comprend un polymère électroactif.

5. Actionneur réversible (100, 300, 400, 500, 800, 901, 1000, 1100) selon l'une quelconque des revendications 1 à 4, dans lequel un changement de forme de la couche électroactive est contraint pour la pluralité de segments (150, 350, 450, 550.1, 550.2, 1050, 1150) en direction radiale (114).

6. Actionneur réversible (100, 300, 400, 500, 800, 901, 1000, 1100) selon la revendication 5, comprenant en outre une pièce centrale (470) au niveau du centre (430), et de préférence dans lequel le changement de forme de la couche électroactive en direction radiale (114) est contraint par la pièce centrale (470).

7. Actionneur réversible (100, 300, 400, 500, 800, 901, 1000, 1100) selon la revendication 6, comprenant en outre une membrane élastique (490) superposée sur le substrat d'actionneur et configurée pour être déformable élastiquement lors de l'application d'une force appliquée à la pièce centrale.

8. Actionneur réversible (100, 300, 400, 500, 800, 901, 1000, 1100) selon l'une quelconque des revendications 1 à 7, comprenant en outre un anneau pivot actif (1051), dans lequel l'anneau pivot actif comprend un matériau électroactif.

9. Actionneur réversible (100, 300, 400, 500, 800, 901, 1000, 1100) selon l'une quelconque des revendications 1 à 8, dans lequel un ou plusieurs de la pluralité de segments comprend une encoche radiale et/ou une encoche arquée (1120, 1121, 1122).

10. Actionneur réversible (100, 300, 400, 500, 800, 901, 1000, 1100) selon l'une quelconque des revendications 1 à 9, dans lequel la pluralité de segments (150, 350, 450, 550.1, 550.2, 1050, 1150) sont agencés pour former une partie saillante (110, 310, 410, 510.1, 510.2), qui fait saillie vers une surface du substrat d'actionneur (102).

11. Actionneur réversible (100, 300, 400, 500, 800, 901, 1000, 1100) selon la revendication 10, dans lequel la partie saillante (110, 310, 410, 510.1, 510.2) comprend une hauteur (112), et comprend en outre une première configuration et une seconde configuration, dans lequel dans la première configuration la hauteur (112) est différente que dans la seconde configuration.

12. Actionneur réversible (100, 300, 400, 500, 800, 901, 1000, 1100) selon la revendication 11, configuré en outre de sorte que la hauteur (112) est réglable en réponse au signal électrique.

13. Actionneur réversible (100, 300, 400, 500, 800, 901, 1000, 1100) selon la revendication 11 ou 12, dans lequel la première configuration est une configuration de repos.

14. Actionneur réversible (100, 300, 400, 500, 800, 901, 1000, 1100) selon l'une quelconque des revendications 11 à 13, dans lequel la partie saillante est configurée pour être amenée de la première configuration à la seconde configuration par une charge.

15. Procédé de production d'un actionneur réversible (100, 300, 400, 500, 800, 901, 1000, 1100) selon l'une quelconque des revendications 10 à 14, le procédé comprenant :
la fourniture du substrat d'actionneur (102) comprenant la couche électroactive (104) ;
**caractérisé par** :
la découpe au laser de la pluralité de fentes radiales (140, 340, 440, 540.1, 540.2) en le substrat d'actionneur (102), dans lequel au moins certaines des fentes de la pluralité de fentes radiales (140, 340, 440, 540.1, 540.2) se terminent en ouvertures élargies (160, 360, 460, 560.1, 560.2) ;
le pressage à chaud d'une partie du substrat d'actionneur (102) en la partie saillante (110, 310, 410, 510.1, 510.2).

16. Dispositif d'interface de rétroaction haptique comprenant une pluralité d'actionneurs réversibles (100, 300, 400, 500, 800, 901, 1000, 1100) selon l'une quelconque des revendications 1 à 14, dans lequel la pluralité d'actionneurs réversibles (100, 300, 400, 500, 800, 901, 1000, 1100) sont fournis sur un substrat d'actionneur commun, et peuvent être couplés électriquement à un circuit de commande de sorte qu'un signal électrique peut être appliqué indépendamment à chacun de la pluralité d'actionneurs réversibles (100, 300, 400, 500, 800, 901, 1000, 1100), par le circuit de commande.
